# EUROPEAN PATENT APPLICATION

(11) **EP 4 389 928 A1**
(43) Date of publication of application: **26.06.2024**
(21) Application number: 23217579.4
(22) Date of filing: 18.12.2023
(51) Int. Cl.: C23C 14/04, C23C 14/24, C23C 14/26, C23C 14/56, H10K 71/16, C23C 14/12

(54) **DEPOSITION APPARATUS**

(30) Priority: 20.12.2022 KR 20220179461
(71) Applicant: Samsung Display Co., Ltd., Yongin-si, Gyeonggi-do 17113 (KR)
(72) Inventor: KIM, Hyunjae, Yongin-si (KR); KANG, Hyungyu, Yongin-si (KR); CHAE, Jongwook, Yongin-si (KR); HAN, Jongbun, Yongin-si (KR); KIM, Daeyong, Yongin-si (KR); PARK, Gan Young, Yongin-si (KR)
(74) Representative: Marks & Clerk LLP

(57) **Abstract**

An embodiment provides a deposition apparatus including a chamber; and a deposition source disposed in the chamber and including a plurality of nozzles arranged in a first direction. Each of the plurality of nozzles includes at least one first nozzle including a first nozzle hole configured to spray a first deposition material and a second nozzle hole configured to spray a second deposition material, and the deposition source further includes at least one angle controlling structure surrounding the at least one first nozzle.

## Description

### BACKGROUND

### 1. Technical Field

This disclosure relates to a deposition apparatus, and more specifically, to a deposition apparatus that may evenly mix and deposit deposition materials and provide a high angle of incidence.

### 2. Description of the Related Art

A light emitting display device is used as device for displaying an image. The light emitting display device may include a display panel providing a screen displaying an image. The light emitting display device may display an image by a combination of pixels, and the pixel may be realized by a light emitting element such as a light emitting diode.

The light emitting diode may include an anode, a cathode, and a light emitting layer therebetween. The light emitting layer of the light emitting diode may be provided by a deposition method. For example, by disposing a substrate on which light emitting layers are to be provided on a mask in which openings of a pattern are provided in a vacuum chamber, and then passing a material of the light emitting layers through the openings of the mask, the light emitting layers matching the pattern may be deposited on the substrate.

The material of the light emitting layers may be vaporized from a deposition source and discharged from a nozzle to pass through the opening of the mask. In this case, particles of the material may be deposited on the substrate at a constant angle while moving in a straight line at the discharge angle. In case that the particles pass through the opening of the mask, a portion in which they are not evenly deposited (for example, they are not deposited to be uniformly thick) on the substrate (that is, a portion with a non-uniform thickness) may occur due to an angle of incidence of the particles. This portion may be referred to as a shadow.

The above information disclosed in this Background section is only for enhancement of understanding of the background of the disclosure, and therefore it may contain information that does not form the prior art that is already known in this country to a person of ordinary skill in the art.

### SUMMARY

In order to improve a lifespan of the light emitting element, it may be advantageous for the deposition materials to be evenly mixed and deposited. In addition, in order to increase resolution of the display device and increase efficiency of the light emitting element, it may be advantageous to reduce the shadow area by increasing the incident angle of the deposition material. Embodiments are to provide a deposition apparatus that may increase a mixing rate and an incident angle of a deposition material deposited on a substrate.

The technical objectives to be achieved by the disclosure are not limited to those described herein, and other technical objectives that are not mentioned herein would be clearly understood by a person skilled in the art from the description of the disclosure.

An embodiment provides a deposition apparatus including a chamber; and a deposition source disposed in the chamber and including a plurality of nozzles arranged in a first direction. Each of the plurality of nozzles includes at least one first nozzle including a first nozzle hole configured to spray (e.g. spraying) a first deposition material and a second nozzle hole configured to spray (e.g. spraying) a second deposition material, and the deposition source further includes at least one angle controlling structure surrounding the at least one first nozzle.

The first nozzle hole and the second nozzle hole may be arranged on a same line in the first direction.

The at least one first nozzle may include one first nozzle hole and two second nozzle holes disposed on both sides of the first nozzle (e.g. two second nozzle holes, wherein a second nozzle hole is disposed on one side of the first nozzle, and another second nozzle hole is disposed on another side of the first nozzle), and the first and second nozzle holes may be disposed on the same line in the first direction.

The at least one first nozzle may have a round rhombic planar shape.

The first nozzle hole may have a "Y" cross-sectional shape, and the second nozzle hole may have an "I" cross-sectional shape.

A height of the at least one angle controlling structure may be higher than a height of the at least one first nozzle.

An angle formed by a center of an upper end of the at least one first nozzle and an upper end of the at least one angle controlling structure with respect to a horizontal plane may be about 40° or more.

The at least one angle controlling structure may be cylindrical.

The at least one angle controlling structure may have a planar shape of a track shape, an elliptical shape, an egg-like shape, a water drop-like shape, or a round rhombic shape.

The deposition source may further include a first container configured to accommodate (e.g. accommodating) the first deposition material and a second container configured to accommodate (e.g. accommodating) the second deposition material. The first nozzle hole may be connected in fluid communication with the first container through a first passage, and the second nozzle hole may be connected in fluid communication with the second container through a second passage.

The plurality of nozzles may further include at least one second nozzle including a first nozzle hole configured to spray (e.g. spraying) the first deposition material and not including a second nozzle hole configured to spray (e.g. spraying) the second deposition material. At least part of the at least one angle controlling structure surrounds the second nozzle.

The at least one first nozzle includes a plurality of first nozzles, the at least one second nozzle may include a plurality of second nozzles, and the at least one angle controlling structure may include a plurality of angle controlling structures, a number of the at least one of angle controlling structures corresponding to a number of the at least one first and second nozzles. In three adjacent nozzles included in the plurality of nozzles, two nozzles disposed at both sides (e.g. of the three adjacent nozzles) may be the plurality of first nozzles and one nozzle disposed in a center (e.g. of the three adjacent nozzles) may be the at least one second nozzle.

The deposition apparatus may further include an angle limiting plate disposed on the deposition source and extending in the first direction. The angle limiting plate may include a first angle limiting plate and a second angle limiting plate respectively disposed at one side and the other side of the plurality of nozzles in a second direction crossing the first direction.

The at least one first nozzle may include a plurality of first nozzles, and a plurality of first nozzle holes and a plurality of second nozzle holes included in the plurality of first nozzles may be arranged side by side in the first direction.

A distance between an upper end of the first nozzle hole and an upper end of the second nozzle hole may be smaller than or substantially equal to a width of the second nozzle hole.

Another embodiment provides a deposition apparatus including a chamber in which a substrate and a mask are disposed to be aligned; and a deposition source disposed in the chamber and configured to provide (e.g. providing) deposition material to the substrate. The deposition source may include a plurality of nozzles arranged in a first direction and respectively including a first nozzle hole and a second nozzle hole adjacent to each other, and at least one angle controlling structure individually surrounding the plurality of nozzles.

The first nozzle hole and the second nozzle hole may be aligned in the first direction.

Each of the at least one angle controlling structure(s) may have a cylindrical three-dimensional shape.

A center of the at least one angle controlling structure may be a same as a center of the nozzle or a center of the first nozzle hole.

The deposition source may include a first container configured to accommodate (e.g. accommodating) a first deposition material; and a second container configured to accommodate (e.g. accommodating) a second deposition material. The first nozzle hole may be connected in fluid communication with the first container, and the second nozzle hole may be connected in fluid communication with the second container.

At least some of the above and other features of the invention are set out in the claims.

According to the embodiments, it is possible to provide a deposition apparatus that may increase a mixing rate and an incident angle of deposition materials deposited on a substrate. Further, according to the embodiments, there is an advantageous effect that may be recognized throughout the present specification.

### BRIEF DESCRIPTION OF THE DRAWINGS

FIG. 1 schematically illustrates a deposition apparatus according to an embodiment.
FIG. 2 schematically illustrates how a deposition source shown in FIG. 1 moves.
FIG. 3 schematically illustrates a state in which deposition material particles are deposited on a substrate through an opening of a mask.
FIG. 4A illustrates a perspective view of a state in which an angle limiting plate is coupled to a deposition source according to an embodiment, FIG. 4B illustrates a perspective view of a deposition source according to an embodiment, and FIG. 4C illustrates a perspective view of a state in which an angle controlling structure is separated from a deposition source according to an embodiment.
FIG. 5 illustrates a schematic plan view of the deposition source shown in FIG. 4A.
FIG. 6 illustrates a schematic cross-sectional view taken along line A-A' of FIG. 5.
FIG. 7 illustrates a schematic cross-sectional view taken along line B-B' of FIG. 5.
FIG. 8 illustrates a graph of shadow effects in deposition apparatuses according to a comparative example and examples.
FIG. 9, FIG. 10, FIG. 11, and FIG. 12 each illustrate a schematic plan view of a deposition source according to an embodiment.
FIG. 13 illustrates a graph of a deposition profile during deposition using deposition sources according to some embodiments.
FIG. 14 and FIG. 15 each illustrate a graph of a deposition ratio of deposition materials during deposition using a deposition source according to an embodiment.
FIG. 16, FIG. 17, and FIG. 18 each illustrate a schematic plan view of a nozzle and an angle controlling structure of a deposition source according to an embodiment.
FIG. 19 illustrates a schematic cross-sectional view of a stacked structure of a display panel according to an embodiment.

### DETAILED DESCRIPTION OF THE EMBODIMENTS

This disclosure will be described more fully hereinafter with reference to the accompanying drawings, in which embodiments are shown.

A size and thickness of each element illustrated in the drawings are arbitrarily shown for ease of description.

It will be understood that when an element such as a layer, film, area, region, or substrate is referred to as being "on" or "above" another element, it can be directly on the other element or intervening elements may also be present. In contrast, when an element is referred to as being "directly on" another element, there are no intervening elements present.

Throughout this specification, unless explicitly described to the contrary, the word "comprise" and variations such as "comprises" or "comprising" will be understood to imply the inclusion of stated elements but not the exclusion of any other elements.

When an element is referred to as being "on," "connected to," or "coupled to" another element, it may be directly on, connected to, or coupled to the other element or intervening elements or layers may be present. When, however, an element is referred to as being "directly on," "directly connected to," or "directly coupled to" another element, there are no intervening elements or layers present. To this end, the term "connected" may refer to physical, electrical, and/or fluid connection, with or without intervening elements. It may also be understood that if one part and another part are connected, they may or may not be integral with each other.

In the drawings, as symbols x, y, and z used for indicating directions, 'x' is a first direction, 'y' is a second direction perpendicular to the first direction, and 'z' is a third direction perpendicular to the first direction and the second direction.

The term "and/or" includes all combinations of one or more of which associated configurations may define. For example, "A and/or B" may be understood to mean "A, B, or A and B."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

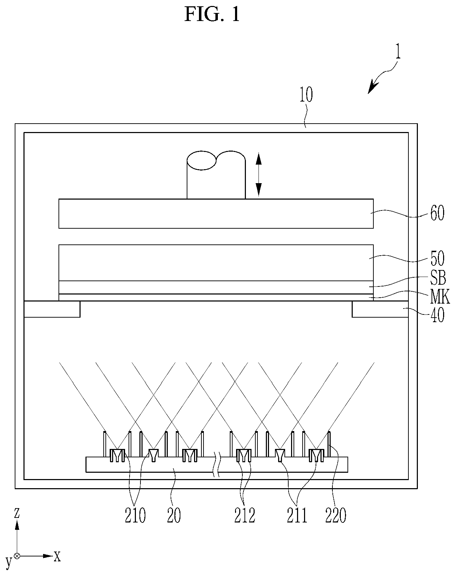

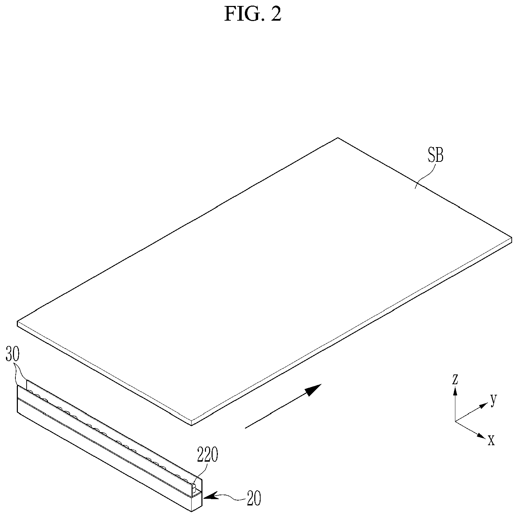

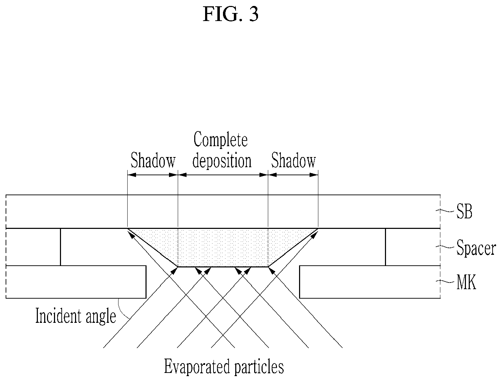

FIG. 1 schematically illustrates a deposition apparatus according to an embodiment, and FIG. 2 schematically illustrates how a deposition source shown in FIG. 1 moves. FIG. 3 schematically illustrates a state in which deposition material particles are deposited on a substrate through an opening of a mask.

Referring to FIG. 1 and FIG. 2, a deposition apparatus 1 according to an embodiment may include a chamber 10, a deposition source 20, an angle limiting plate 30, a holder 40, a cool plate 50, and/or a magnet assembly 60. The deposition source 20, the angle limiting plate 30, the holder 40, the cool plate 50, and the magnet assembly 60 may be disposed within the chamber 10. The angle limiting plate 30 is not shown in FIG. 1, but is shown in FIG. 2.

The chamber 10 may be a vacuum chamber, and the inside of the chamber 10 may be maintained in a vacuum atmosphere or an inert gas atmosphere such as nitrogen gas. The chamber 10 may be connected to a vacuum pump (not shown) to control the internal pressure. Depositing a deposition material on a substrate SB for manufacturing a display panel and the like may be performed in the chamber 10 of the deposition apparatus 1.

The substrate SB may be fixed at a position (e.g., a predetermined or selectable position) inside the chamber 10. Under the substrate SB, a mask MK may be disposed to align with the substrate SB. The mask MK may be detachably fixed to the holder 40 above the deposition source 20. The mask MK may be a fine metal mask having an opening corresponding to a pattern of a layer to be provided on the substrate SB (for example, a pattern of a light emitting layer of a display device). The mask MK may be an open mask having an opening corresponding to a layer (for example, a common layer of a display panel) to be provided in an area (e.g., a predetermined or selectable area) of the substrate SB. As the mask MK is disposed between the deposition source 20 and the substrate SB, the deposition material may be deposited in a pattern (e.g., a predetermined or selectable pattern) on the substrate SB. The chamber 10 may include a carry-in/out port (not shown) for carrying the substrate SB and the mask MK in and out.

The deposition source 20 may provide a deposition material to the substrate SB to be deposited by storing and evaporating the deposition material (for example, a light emitting layer material of a light emitting display panel). The deposition source 20 may inject the deposition material toward the substrate SB. The deposition source 20 may be a linear deposition source.

The deposition source 20 may have a length in the first direction x and a width in the second direction y, and the length may be greater than the width. The deposition source 20 may include nozzles 210 for spraying the deposition material. The nozzles 210 may be disposed in a line in the first direction x on an upper portion of the deposition source 20. The nozzles 210 may be disposed in columns in the first direction x. The nozzle 210 may include a first nozzle hole 211 and/or a second nozzle hole 212, or may include a first nozzle hole 211.

The deposition source 20 may include angle controlling structures 220 surrounding the nozzles 210. The angle controlling structure 220 may have a rolled plate shape or, for example, a cylindrical shape. The angle controlling structure 220 may have a circular planar shape. An angle controlling structure 220 may surround a nozzle 210. An angle controlling structure 220 may surround a first nozzle hole 211 and one or more second nozzle holes 212, or may surround a first nozzle hole 211.

The angle controlling structures 220 may control an incident angle of a deposition material so that the incident angle of the deposition material sprayed from the nozzles 210 to be directed to the substrate SB through the opening of the mask MK is an angle (e.g., a predetermined or selectable angle) or more. For example, the angle controlling structure 220 may restrict particles, of which an incident angle is an angle (e.g., a predetermined or selectable angle) or less, from reaching the mask MK and the substrate SB. Referring to FIG. 3, since a shadow area becomes wider as the incident angle is smaller, in case that the incident angle is increased, the shadow area may be reduced, and deposition quality may be improved. The incident angle may be increased by improving the spray angle of the nozzle by improving the shape of the nozzle, but since the particle density around the nozzle is high, it may be difficult to increase the incident angle to an angle (e.g., a predetermined or selectable angle) or more only by improving the nozzle shape. As in the embodiment, by disposing the angle controlling structure 220 surrounding the nozzle 210 to block particles sprayed from the nozzle 210 at a low incident angle, it is possible to increase the incident angle. A detailed configuration of the angle controlling structure 220 will be described below.

The angle limiting plate 30 may be disposed long in the first direction x at a side and another side along a row of the nozzles 210. The angle limiting plate 30 can be disposed to be perpendicular to an x-y plane. The angle limiting plate 30 may limit the spraying direction of the deposition material sprayed from the nozzles 210. The angle limiting plate 30 may limit movement of deposition material particles having a relatively low incident angle.

In order to closely contact the mask MK to the substrate SB, the magnet assembly 60 may be disposed above the substrate SB. The magnet assembly 60 may include magnets (not shown) and a yoke plate (not shown) supporting the magnets. The mask MK may be pulled toward the magnet assembly 60 by the magnetic force of the magnets of the magnet assembly 60, so the mask MK may be attached to and closely contact the substrate SB. Accordingly, it is possible to reduce a lifting phenomenon between the mask MK and the substrate SB, and to reduce a shadow effect during the deposition process. The magnet assembly 60 may be provided to move in a third direction z, and the deposition apparatus 1 may include an actuator for moving the magnet assembly 60 in one or more directions.

The cool plate 50 may be disposed between the substrate SB and the magnet assembly 60 to pressurize the substrate SB with its own weight, and a close contacting degree between the substrate SB and the mask MK may be improved. The cool plate 50 may be non-magnetic so as to not affect magnetism of the magnet assembly 60.

FIG. 2 briefly illustrates a relationship between the substrate SB and the deposition source 20 disposed in the chamber 10 of the deposition apparatus 1. The substrate SB may be disposed above the deposition source 20 to be spaced apart away from the deposition source 20. A surface of the substrate SB (for example, a surface on which the deposition material is deposited) may face the deposition source 20. The substrate SB may include two sides extending in the first direction x and two sides extending in the second direction y. The substrate SB may have a substantially quadrangular planar shape. The deposition source 20 may be disposed so as to extend in the first direction x, for example, so that a length direction of the deposition source 20 is parallel to the first direction x. The deposition source 20 may move in the second direction y. For example, in case that the deposition source 20 moves in the second direction y in a state in which the position of the substrate SB is fixed, the deposition material may be provided on a surface of the substrate SB. The deposition source 20 may provide deposition materials containing different materials to the substrate SB. Uniform mixing of the deposition materials may improve characteristics such as color coordinates, light efficiency, a driving voltage, and a lifespan of the display device.

Hereinafter, a structure of the deposition source 20 that may improve a mixing rate and an incident angle of the deposition materials, will be described in detail.

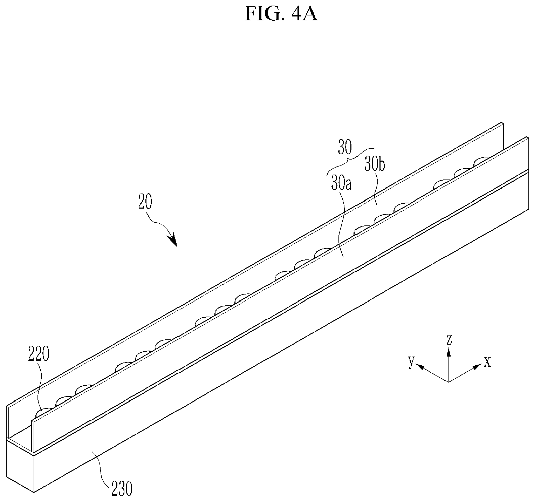

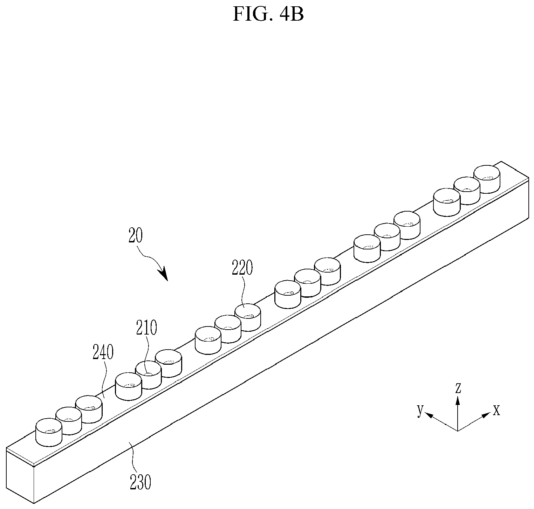

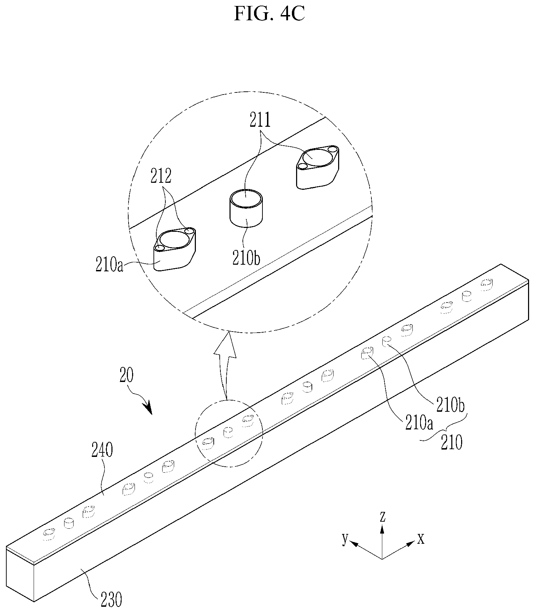

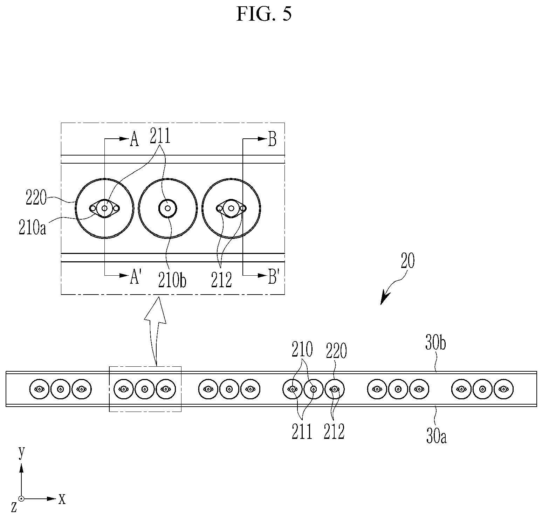

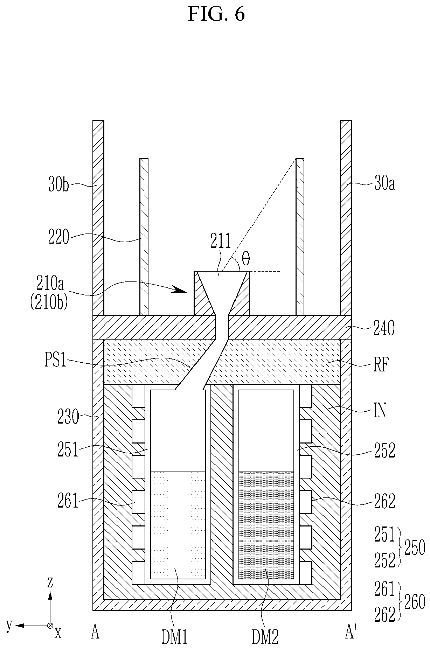

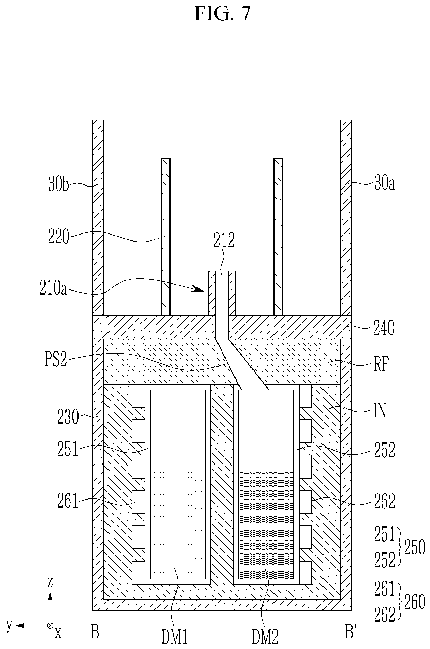

FIG. 4A illustrates a schematic perspective view of a state in which an angle limiting plate is coupled to a deposition source according to an embodiment, FIG. 4B illustrates a schematic perspective view of a deposition source according to an embodiment, and FIG. 4C illustrates a schematic perspective view of a state in which an angle controlling structure is separated from a deposition source according to an embodiment. FIG. 5 illustrates a schematic plan view of the deposition source shown in FIG. 4A, FIG. 6 illustrates a schematic cross-sectional view taken along line A-A' of FIG. 5, and FIG. 7 illustrates a schematic cross-sectional view taken along line B-B' of FIG. 5.

Referring to FIG. 4A, FIG. 4B, FIG. 4C, FIG. 5, FIG. 6, and FIG. 7, the deposition source 20 according to an embodiment may include the nozzles 210, the angle controlling structures 220, a main body 230, a cover 240, a container or crucible (hereinafter referred to as "crucible") 250, a heater 260, and/or a reflector RF.

The main body 230 and the cover 240 may configure an overall appearance of the deposition source 20. The main body 230 and the cover 240 may extend in the first direction x. The cover 240 may be coupled to an upper portion of the main body 230. The cover 240 may be separable from the main body 230. The main body 230 and the cover 240 may be combined to define an inner space of the deposition source 20.

The nozzles 210 may be disposed to protrude from the cover 240 (e.g. in a direction away from an inner space of the deposition source 20). The nozzles 210 may be separately manufactured from the cover 240 to be coupled to the cover 240. The nozzles 210 may be integral with the cover 240. The nozzles 210 may be disposed in the first direction x. A distance between adjacent nozzles 210 may or may not be constant. For example, three nozzles 210 may be disposed adjacently as shown, but the distance between the nozzles 210 may be variously changed. Eighteen nozzles 210 are shown, but the number of the nozzles 210 may be variously changed.

The nozzles 210 may include first nozzles 210a including the first nozzle hole 211 and the second nozzle hole 212 and second nozzles 210b including the first nozzle hole 211 and not including the second nozzle hole 212. For example, the first nozzle 210a may be a nozzle including both the first nozzle hole 211 and the second nozzle hole 212, and the second nozzle 210b may be a nozzle including only the first nozzle hole 211. The second nozzle 210b may include the second nozzle hole 212 instead of the first nozzle hole 211. The nozzles 210 disposed at sides (e.g., both sides) of three adjacent nozzles 210 may be the first nozzles 210a, and the nozzle 210 disposed at a center thereof may be the second nozzle 210b. A planar shape of the first nozzle 210a may be a substantially round rhombic shape or a substantially elliptical shape. A planar shape of the second nozzle 210b may be a substantially circular shape. The disposition of the first nozzle 210a and the second nozzle 210b may be variously changed, and the nozzles 210 may not include the second nozzle 210b.

In the first nozzle 210a, a first nozzle hole 211 may be disposed at a center thereof, and two second nozzle holes 212 may be disposed at sides of the first nozzle hole 211. The first nozzle hole 211 and the second nozzle holes 212 may be aligned in the first direction x. For example, the first nozzle hole 211 and the second nozzle holes 212 may be disposed on a straight line in the first direction x. The number and disposition of the second nozzle holes 212 in the first nozzle 210a may be variously changed.

A first deposition material DM1 may be sprayed through the first nozzle hole 211, and a second deposition material DM2 may be sprayed through the second nozzle hole 212. The first deposition material DM1 and the second deposition material DM2 may be different materials. For example, the first deposition material DM1 may be a host, and the second deposition material DM2 may be a guest (e.g. dopant). The second nozzle hole 212 may be disposed to be substantially close to the first nozzle hole 211, and for example, a distance between an upper end of the first nozzle hole 211 and an upper end of the second nozzle hole 212 may be smaller than or substantially equal to a width (for example, an inner diameter) of the second nozzle hole 212. The distance between the upper end of the first nozzle hole 211 and the upper end of the second nozzle hole 212 may be substantially zero. Accordingly, the mixing ratio of the first deposition material DM1 sprayed through the first nozzle hole 211 and the second deposition material DM2 sprayed through the second nozzle hole 212 may be improved, and the first deposition material DM1 and the second deposition material DM2 may be entirely deposited with the improved mixing rate on the substrate SB.

The first nozzle hole 211 may have a "Y"-shaped cross-sectional shape (e.g. in a cross-sectional plane intersecting the first direction x), and the second nozzle hole 212 may have an "I"-shaped cross-sectional shape (e.g. in a cross-sectional plane intersecting the first direction x). The "Y"-shaped nozzle hole may have a three-dimensional shape having a constant width in the third direction z and then gradually widening, similar to a funnel. The "I"-shaped nozzle hole may have a cylinder shape with a constant width in the third direction z (i.e. shaped like a capital letter "I" without serifs). The "Y"-shaped nozzle hole may be more advantageous than the "I"-shaped nozzle hole in realizing a high incident angle of the deposition material. In case that a cross-section of at least one of the first nozzle hole 211 and the second nozzle hole 212 has a "Y" shape, an upper end of the first nozzle hole 211 and an upper end of the second nozzle hole 212 may substantially directly contact each other. The cross-sectional shapes or dimensions of the first and second nozzle holes 211 and 212 may be variously changed according to the type and the spray amount of the deposition material.

The angle controlling structures 220 may be disposed to protrude from the cover 240 (e.g. in a direction away from an inner space of the deposition source 20) while surrounding the nozzles 210. An angle controlling structure 220 may surround a nozzle 210. The number of the angle controlling structures 220 may correspond 1:1 to the number of the nozzles 210. The number of the angle controlling structures 220 may not correspond to the number of the nozzles 210. For example, at least some of the first nozzles 210a and/or at least some of the second nozzles 210b may not be surrounded by the angle controlling structure 220. The angle controlling structure 220 may completely surround a side surface of the nozzle 210. In a plan view, a center of the angle controlling structure 220 and a center of the nozzle 210 and/or the first nozzle hole 211 may be substantially the same. A height of the angle controlling structure 220 may be higher than that of the nozzle 210. For example, with respect to a horizontal plane corresponding to the x-y plane, an angle θ formed by a center of an upper end of the nozzle 210 and an upper end of the angle controlling structure 220 (hereinafter referred to as an exit angle) may be about 40° or more, or about 60° to about 80°. The angle controlling structure 220 may have a cylindrical or barrel shape, but may have various three-dimensional shapes with an empty interior such as an elliptical columnar shape and a prismatic shape. The angle controlling structure 220 can be disposed to be perpendicular to the x-y plane.

The angle controlling structures 220 may be separately manufactured from the cover 240 and may be coupled to the cover 240. The angle controlling structures 220 may be integral with the cover 240. The angle controlling structures 220 may be disposed at intervals corresponding to intervals between the nozzles 210. For example, three angle controlling structures 220 may be disposed adjacently as shown. Although 18 angle controlling structures 220 are shown, the number of the angle controlling structures 220 may correspond to the number of the nozzles 210. The angle controlling structure 220 surrounding the first nozzle 210a and the angle controlling structure 220 surrounding the second nozzle 210b may have substantially a same shape, but may have different shapes in other embodiments. The angle controlling structures 220 may be designed to be able to be cooled or heated.

Particles of the first and second deposition materials DM1 and DM2 may be sprayed from the first and second nozzle holes 211 and 212 of the first nozzle 210a at a spray angle (e.g., a predetermined or selectable spray angle). Particles of the first deposition material DM1 may be sprayed from the first nozzle hole 211 of the second nozzle 210b at a spray angle (e.g., a predetermined or selectable spray angle). The angle controlling structure 220 may limit, among the particles sprayed from the nozzle 210, movement of particles sprayed at an angle (e.g., a predetermined or selectable angle) or less. The angle (e.g., a predetermined or selectable angle) may correspond to the exit angle θ. The particles sprayed at the angle (e.g., a predetermined or selectable angle) or less may be blocked by the angle controlling structure 220 and may not substantially move outside the angle controlling structure 220. Accordingly, only particles having a greater incident angle than particles filtered by the angle controlling structure 220 may pass above the angle controlling structure 220 to be deposited on the substrate SB. Therefore, the shadow area may be reduced because the particles with a high incident angle substantially greater than the exit angle θ may be deposited on the substrate SB.

The particles filtered by the angle controlling structure 220 may be deposited on the angle controlling structure 220. In order to prevent the particles deposited on the angle controlling structure 220 from being accumulated and falling, the angle controlling structure 220 may have a mesh shape. For example, the angle controlling structure 220 may be provided to have a wire mesh such as a woven wire mesh or a welded wire mesh. The angle controlling structure 220 may have a mesh shape as a whole, or only an inner surface thereof (for example, a surface facing the nozzle 210) may have a mesh shape. For example, the angle controlling structure 220 may have a structure in which a metal wire mesh is provided on an inner surface of a cylindrical metal plate.

The crucible 250 may be disposed inside the main body 230. The crucible 250 may include a first crucible 251 and a second crucible 252. The first crucible 251 and the second crucible 252 may each extend in the first direction x. The first crucible 251 and the second crucible 252 may be spaced apart from each other in the second direction y. A volume of the first crucible 251 and a volume of the second crucible 252 may be the same, but may be different in other embodiments. The first crucible 251 may accommodate the first deposition material DM1, and the second crucible 252 may accommodate the second deposition material DM2. For example, the first deposition material DM1 may be a host material, and the second deposition material DM2 may be a dopant material.

The first crucible 251 may be connected in fluid communication with the first nozzle hole 211 through a first passage PS1, and the second crucible 252 may be connected in fluid communication with the second nozzle hole 212 through a second passage PS2. Accordingly, the first deposition material DM1 in the first crucible 251 may be sprayed out of the deposition source 20 through the first passage PS1 and the first nozzle hole 211, and the second deposition material DM2 in the second crucible 252 may be sprayed out of the deposition source 20 through the second passage PS2 and the second nozzle hole 212. For example, the first passage PS1 may be a tube, a hole formed in a structure disposed between the first crucible 251 and the first nozzle hole 211, or a combination of a tube and a hole. Similarly, the second passage PS2 may be a tube, a hole formed in a structure disposed between the second crucible 252 and the second nozzle hole 212, or a combination of a tube and a hole.

In case that the first deposition material DM1 and the second deposition material DM2 are mixed inside the deposition source 20, a reverse flow of one of the first and second deposition materials DM1 and DM2 may occur due to a vaporization temperature difference between the first deposition material DM1 and the second deposition material DM2. In the deposition source 20 according to the embodiment, the first deposition material DM1 and the second deposition material DM2 are not mixed inside the deposition source 20 and may be sprayed outside the deposition source 20 through their respective channels, so that the problem such as the reverse flow of the first or second deposition material DM1 or DM2 may not occur.

The heater 260 may be disposed within the main body 230 to heat the crucible 250. The heater 260 may include a first heater 261 and a second heater 262. The first heater 261 may heat the first crucible 251 to evaporate the first deposition material DM1 in the first crucible 251. The second heater 262 may heat the second crucible 252 to evaporate the second deposition material DM2 in the second crucible 252. The first heater 261 may be disposed between an inner wall of the main body 230 and the first crucible 251, and the second heater 262 may be disposed between the inner wall of the main body 230 and the second crucible 252, but the position of the heater 260 may be variously changed. For example, the first heater 261 may be disposed on a side surface of the first crucible 251 and/or under the first crucible 251, and the second heater 262 may be disposed on a side surface of the second crucible 252 and/or under the second crucible 252. The first heater 261 and the second heater 262 may independently operate. For example, an amount of heat energy applied to the first crucible 251 by the first heater 261 may be different from an amount of heat energy applied to the second crucible 252 by the second heater 262. Accordingly, the first crucible 251 and the second crucible 252 may be heated at different temperatures, and an internal temperature of the first crucible 251 and an internal temperature of the second crucible 252 may be different.

An insulating wall IN surrounding the first crucible 251 and the second crucible 252 may be disposed inside the main body 230. The insulating wall IN may prevent heat inside the main body 230 from leaking out of the main body 230. Accordingly, it is possible to suppress heat generated from the deposition source 20 from being dissipated into the chamber 10, and to prevent heat from affecting the substrate SB or damaging structures inside the chamber 10. The insulating wall IN may be disposed between the first crucible 251 and the second crucible 252 to block thermal exchange between the first crucible 251 and the second crucible 252. Accordingly, temperatures of the first crucible 251 and the second crucible 252 may be readily independently controlled.

A reflector RF may be disposed between the nozzle 210 and the crucible 250. For example, the reflector RF may include an insulating material. The reflector RF may prevent heat from the first crucible 251 and the second crucible 252 from leaking in an upper direction of the main body 230. Accordingly, the reflector RF may block heat from the deposition source 20 leaking toward the substrate SB. In other embodiments, unlike as shown, the reflector RF may be disposed on the cover 240, or the cover 240 may function as the reflector RF.

The angle limiting plate 30 may be disposed on the deposition source 20. A lower end portion of the angle limiting plate 30 may contact the deposition source 20. For example, the angle limiting plate 30 may be disposed on the cover 240 and the lower end portion thereof may contact the cover 240. The angle limiting plate 30 may be combined with the cover 240 or integral with the cover 240. The angle limiting plate 30 may include a first angle limiting plate 30a and a second angle limiting plate 30b respectively disposed at a side and another side of the nozzles 210. The first and second angle limiting plates 30a and 30b may be disposed long in the first direction x along the row of the nozzles 210. The first and second angle limiting plates 30a and 30b may be disposed to be spaced apart from each other with the nozzles 210 and the angle controlling structures 220 therebetween in the second direction y. A height of the angle limiting plate 30 may be higher than that of the nozzles 210 and/or that of the angle controlling structures 220 (e.g. higher than that of the nozzles 210 and that of the angle controlling structures 220). The angle limiting plate 30 may limit sprayed directions of the first and second deposition materials DM1 and DM2 sprayed from the first and second nozzle holes 211 and 212 of the nozzles 210. Accordingly, it is possible to reduce an amount of waste deposition material that is not deposited on the substrate SB.

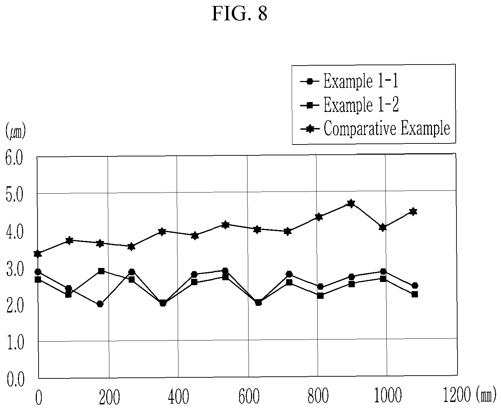

FIG. 8 illustrates a graph of shadow effects in deposition apparatuses according to a comparative example and examples.

Referring to FIG. 8, a horizontal axis in the graph may represent a position of a substrate, and a vertical axis may represent a width of a shadow area. Example 1-1 and Example 1-2 illustrate the widths of the shadow areas during deposition using the deposition source 20 shown in FIG. 5, and Example 1-1 and Example 1-2 respectively may be cases in which the exit angles θ are about 52° and about 50°. The comparative example illustrates the width of the shadow area during deposition using a deposition source not including the angle controlling structure 220 in the deposition source 20 shown in FIG. 5. In Example 1-1 and Example 1-2, the width of the shadow area ranged from about 2.0 µm to about 2.9 µm according to the position of the substrate. In the comparative example, the width of the shadow area ranged from about 3.4 µm to about 4.7 µm according to the position of the substrate. As in Example 1-1 and Example 1-2, during deposition using the deposition source 20 including the angle controlling structure 220, the width of the shadow area was significantly reduced compared to the comparative example. A difference between a minimum value and a maximum value of the shadow area according to the position of the substrate was about 1.3 µm in the comparative example, but was about 0.9 µm, as an improved value, in Example 1-1 and Example 1-2.

On the other hand, material efficiencies (%) calculated as (deposition amount/evaporation amount) x 100 were about 51.0 %, about 49.2 %, and about 50.4 %, in the comparative example, Example 1-1, and Example 1-2, respectively. It can be seen that the material efficiency was not significantly reduced compared to the case of using the deposition source not including the angle controlling structure 220, even though the angle controlling structure 220 was used to limit low incident angle particles. As described above, the deposition source 20 including the angle controlling structure 220 according to the embodiment may reduce a shadow effect without substantially reducing material efficiency.

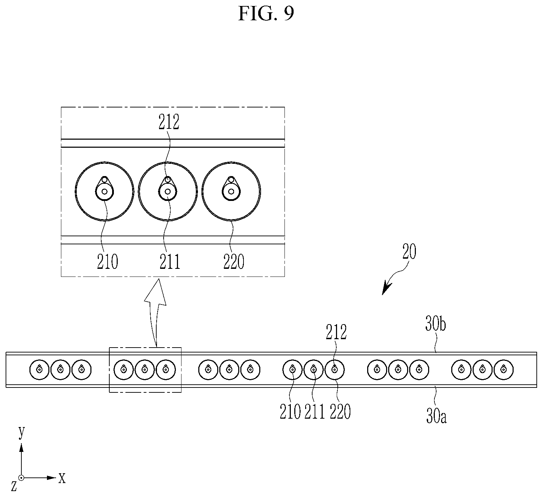

FIG. 9, FIG. 10, FIG. 11, and FIG. 12 each illustrate a schematic plan view of a deposition source according to an embodiment.

The embodiments shown in FIG. 9, FIG. 10, FIG. 11, and FIG. 12 may be different from the embodiment shown in FIG. 5 in the disposition of the second nozzle hole 212.

Referring to FIG. 9, similar to the embodiment described above, the deposition source 20 may include the nozzles 210 disposed in the first direction x, and may include the angle controlling structures 220 surrounding the nozzles 210. An angle controlling structure 220 may surround a nozzle 210. The nozzle 210 may have a planar shape of an approximately water-drop shape in which an approximately semicircular shape and an approximately semi-elliptical shape are combined. The nozzle 210 may include the first nozzle hole 211 and the second nozzle hole 212. The second nozzle hole 212 may be disposed in front of the first nozzle hole 211 (e.g. for each nozzle 210, the respective first nozzle hole 211 and the respective second nozzle hole 212 may be disposed on a straight line in the second direction y), for example, to be directed to the second direction y, which may be a movement direction of the deposition source 20 during deposition. A distance between the upper end of the first nozzle hole 211 and the upper end of the second nozzle hole 212 in the second direction y may be less than or substantially equal to the width of the second nozzle hole 212, for example, substantially zero. The upper end of the first nozzle hole 211 and the upper end of the second nozzle hole 212 may substantially directly contact each other. The first nozzle holes 211 may be aligned in the first direction x, and the second nozzle holes 212 may be aligned in the first direction x. The first nozzle holes 211 and the second nozzle holes 212 may be aligned side by side in the first direction x. For example, a line connecting the centers of the first nozzle holes 211 and a line connecting the centers of the second nozzle holes 212 in the first direction x may be side by side and may be spaced apart from each other by a distance between the centers of the adjacent first and second nozzle holes 211 and 212. Although respective nozzles 210 are illustrated as including the first nozzle hole 211 and the second nozzle hole 212, some nozzles may include only the first nozzle hole 211 or only the second nozzle hole 212.

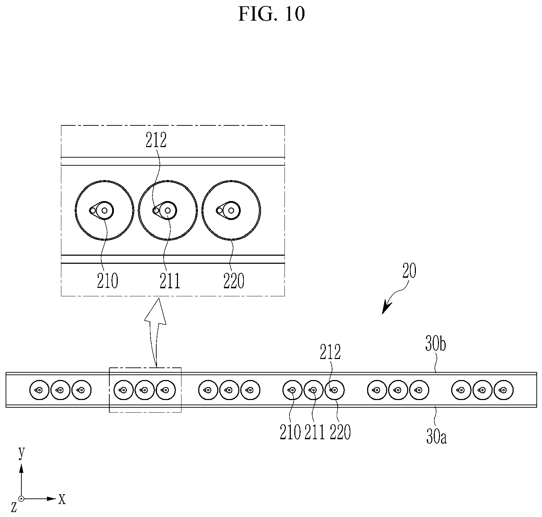

Referring to FIG. 10, the deposition source 20 may include the nozzles 210 disposed in the first direction x, and may include the angle controlling structures 220 surrounding the nozzles 210. An angle controlling structure 220 may surround a nozzle 210. The nozzle 210 may have a planar shape of an approximately water-drop shape in which an approximately semicircular shape and an approximately semi-elliptical shape are combined. The nozzle 210 may include the first nozzle hole 211 and the second nozzle hole 212. The second nozzle hole 212 may be disposed at a side of the first nozzle hole 211. A distance between the upper end of the first nozzle hole 211 and the upper end of the second nozzle hole 212 may be less than or substantially equal to the width of the second nozzle hole 212, for example, substantially zero. The first nozzle holes 211 and the second nozzle holes 212 may be disposed on a straight line extending in the first direction x. In each nozzle 210, it is shown that the second nozzle hole 212 is disposed at the left side of the first nozzle hole 211, but the second nozzle hole 212 may be disposed at the right side of the first nozzle hole 211. Although respective nozzles 210 are illustrated as including the first nozzle hole 211 and the second nozzle hole 212, some nozzles may include only the first nozzle hole 211 or only the second nozzle hole 212.

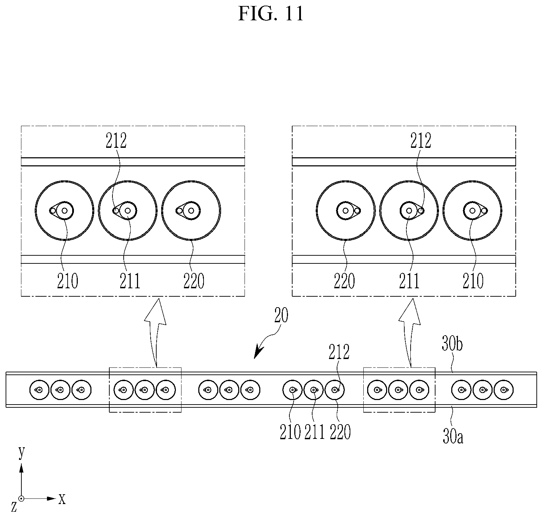

Referring to FIG. 11, there may be a difference in the position of the second nozzle hole 212 compared to the embodiment of FIG. 10. Based on the center of the deposition source 20 in the first direction x, the second nozzle hole 212 in the nozzle 210 disposed at a left side (of the deposition source 20) may be disposed at the left side of the first nozzle hole 211, and the second nozzle hole 212 in the nozzle 210 disposed at a right side (of the deposition source 20) may be disposed at the right side of the first nozzle hole 211. Conversely, in other embodiments (not shown), based on the center of the deposition source 20 in the first direction x, the second nozzle hole 212 in the nozzle 210 disposed at the left side (of the deposition source 20) may be disposed at the right side of the first nozzle hole 211, and the second hole 212 in the nozzle 210 disposed at the right side (of the deposition source 20) may be disposed at the left side of the first nozzle hole 211.

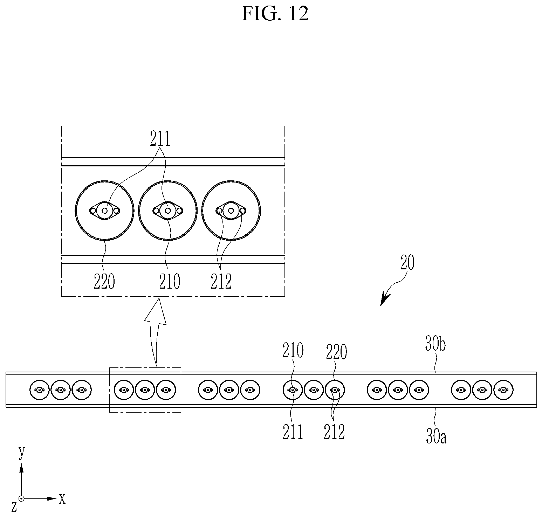

Referring to FIG. 12, there may be a difference at least in that the second nozzle holes 212 are disposed at sides of the first nozzle hole 211, compared to the embodiment of FIG. 10. For example, each nozzle 210 may include a first nozzle hole 211 and two second nozzle holes 212, and the two second nozzle holes 212 may be disposed at the sides of the first nozzle hole 211. The nozzle 210 may have a substantially round rhombus shape or a substantially elliptical planar shape. The first nozzle hole 211 and the second nozzle holes 212 may be aligned in the first direction x. The embodiment of FIG. 12 may differ from the embodiment of FIG. 5 at least in that all nozzles 210 include the second nozzle holes 212.

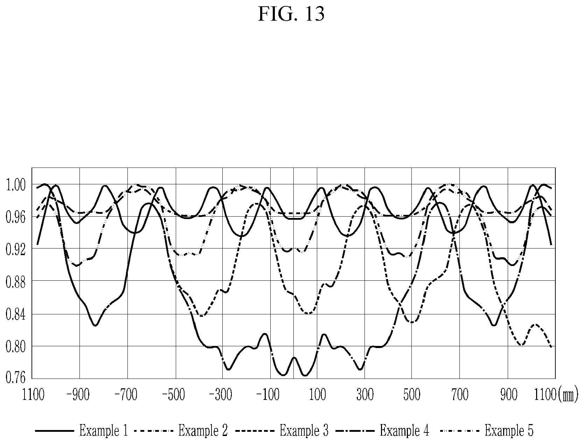

FIG. 13 illustrates a graph of a deposition profile during deposition using deposition sources according to some embodiments.

In FIG. 13, the horizontal axis may represent a position on the substrate, and the vertical axis may represent a relative thickness of the deposition material. In FIG. 13, Example 1 may be an example of deposition using the deposition source according to the embodiment of FIG. 5, Example 2 may be an example of deposition using the deposition source according to the embodiment of FIG. 9, Example 3 may be an example of deposition using the deposition source according to the embodiment of FIG. 10, Example 4 may be an example of deposition using the deposition source according to the embodiment of FIG. 11, and Example 5 may be an example of deposition using the deposition source according to the embodiment of FIG. 12. As shown, deposition profiles of Example 1 and Example 2 were relatively uniform. Between Example 1 and Example 2, Example 2 was more uniform. As in Example 3 and Example 4, the second nozzle holes 212 were aligned with the first nozzle holes 211 in the first direction x, but in case that the second nozzle hole 212 was disposed at a side of the first nozzle hole 211, a thickness change of the deposition material was relatively large depending on the position on the substrate. Comparing Example 1 and Example 5, the deposition profile was more uniform in Example 1 in which some nozzles 210 did not include the second nozzle hole 212 than in Example 5 in which all nozzles 210 included the second nozzle hole 212.

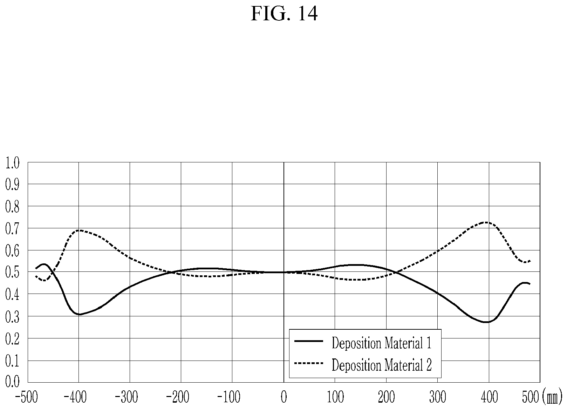

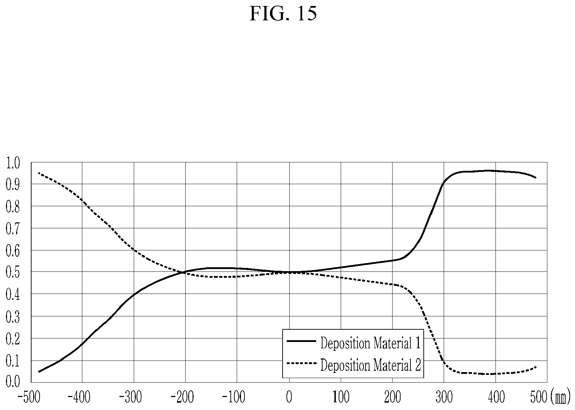

FIG. 14 and FIG. 15 each illustrate a graph of a deposition ratio of deposition materials during deposition using a deposition source according to an embodiment.

In FIG. 14 and FIG. 15, the horizontal axis may represent a position of the substrate relative to the deposition source, and the vertical axis may represent a deposition ratio of Deposition Material 1 and Deposition Material 2. Deposition Material 1 may represent the deposition material sprayed through the first nozzle hole 211, and Deposition Material 2 may represent the deposition material sprayed through the second nozzle hole 212. FIG. 14 illustrates a deposition ratio during deposition using the deposition source according to the embodiment of FIG. 5 (corresponding to Example 1 in FIG. 13), and FIG. 15 illustrates a deposition ratio during deposition using the deposition source according to the embodiment of FIG. 9 (corresponding to Example 2 in FIG. 13). Referring to FIG. 14, Deposition Material 1 and Deposition Material 2 were deposited within a range of about 0.3 to about 0.7. Referring to FIG. 15, Deposition Material 1 and Deposition Material 2 were deposited within a wide range of about 0.05 to about 0.95, and it was found that at first Deposition Material 1 was mainly deposited and below Deposition Material 2 was mainly deposited. From these results, it can be seen that the case of using the deposition source in which the first nozzle holes 211 and the second nozzle holes 212 are aligned in a straight line has a more uniform deposition ratio of Deposition Material 1 and Deposition Material 2 and a more uniform mixing ratio thereof accordingly than the case of using the deposition source in which the first nozzle holes 211 and the second nozzle holes 212 are adjacent but aligned side by side.

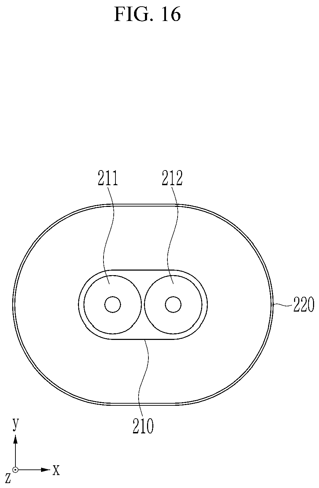

FIG. 16, FIG. 17, and FIG. 18 each illustrate a schematic plan view of a nozzle and an angle controlling structure of a deposition source according to an embodiment.

FIG. 16 illustrates a nozzle 210 and an angle controlling structure 220 surrounding a nozzle 210. The nozzle 210 may include the first nozzle hole 211 through which the first deposition material may be sprayed and the second nozzle hole 212 through which the second deposition material may be sprayed. The first nozzle hole 211 and the second nozzle hole 212 may have a "Y"-shaped cross-sectional shape (e.g. in a cross-sectional plane intersecting the first direction x). An upper end of the first nozzle hole 211 and an upper end of the second nozzle hole 212 may be adjacent to or substantially contact each other. The first nozzle hole 211 and the second nozzle hole 212 may be aligned in the first direction x. In order to accommodate the first and second nozzle holes 211 and 212, the planar shape of the nozzle 210 may be substantially a track shape extending in the first direction x or substantially an elliptical shape. Corresponding to the planar shape of the nozzle 210, the angle controlling structure 220 may have a substantially track shape or a substantially elliptical shape extending in the first direction x.

As described above, in case that the first and second nozzle holes 211 and 212 included in a nozzle 210 are configured to have a "Y" shape, and in case that the first deposition material and the second deposition material are deposited in similar amounts, it may be advantageous to implement a high angle of incidence. Since each material to be deposited has different characteristics, control of the incident angle of the deposition materials may be optimized by changing and combining the shape of the first nozzle hole 211, the shape of the second nozzle hole 212, and the shape of the angle controlling structure 220. At least one of the nozzles 210 and the angle controlling structures 220 shown in FIG. 5, FIG. 9, FIG. 10, FIG. 11, and FIG. 12 may have the structure shown in FIG. 16.

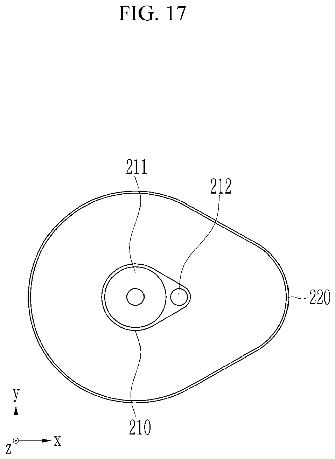

FIG. 17 illustrates a nozzle 210 and an angle controlling structure 220 surrounding the nozzle 210. The nozzle 210 may include the first nozzle hole 211 through which the first deposition material may be sprayed and the second nozzle hole 212 through which the second deposition material may be sprayed. The second nozzle hole 212 having an "I"-shaped cross-sectional shape (e.g. in a cross-sectional plane intersecting the first direction x) may be disposed at a side of the first nozzle hole 211 having a "Y"-shaped cross-sectional shape (e.g. in a cross-sectional plane intersecting the first direction x). The first and second nozzle holes 211 and 212 may be aligned in the first direction x. The nozzle 210 may have a planar shape of an egg-like shape or an approximately water-drop shape in which an approximately semicircular shape and an approximately semi-elliptical shape are combined. The angle controlling structure 220 may have a planar shape of a substantially egg-like shape or a substantially droplet-like shape in which a semi-circular shape and a semi-elliptical shape are combined, corresponding to the planar shape of the nozzle 210.

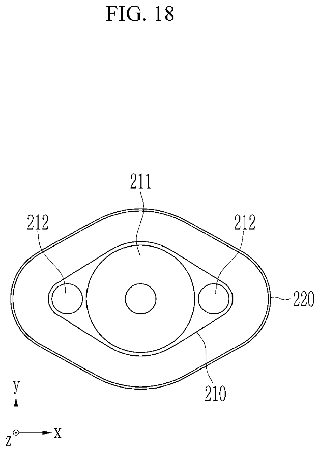

FIG. 18 illustrates a nozzle 210 and an angle controlling structure 220 surrounding the nozzle 210. The nozzle 210 may include the first nozzle hole 211 through which the first deposition material may be sprayed and the second nozzle holes 212 through which the second deposition material may be sprayed. The second nozzle holes 212 may be disposed at sides of the first nozzle hole 211, and the first and second nozzle holes 211 and 212 may be aligned in the first direction x. The first nozzle hole 211 may have a "Y"-shaped cross-sectional shape (e.g. in a cross-sectional plane intersecting the first direction x), and the second nozzle hole 212 may have an "I"-shaped cross-sectional shape (e.g. in a cross-sectional plane intersecting the first direction x). The nozzle 210 may have a substantially round rhombus planar shape. The angle controlling structure 220 may have a substantially round rhombus planar shape corresponding to the planar shape of the nozzle 210.

As shown in FIG. 17 and FIG. 18, the planar shape of the angle controlling structure 220 is not limited to the round shape, and may be changed in consideration of a planar shape corresponding to the planar shape of the nozzle 210. Since the characteristic is different for each material to be deposited, it is possible to optimize the control of the incident angle of the deposition materials by changing the shape of the angle controlling structure 220.

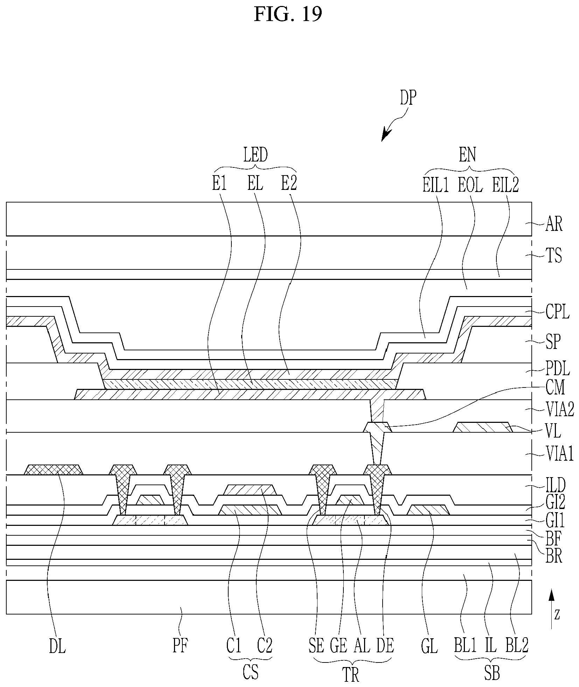

FIG. 19 illustrates a schematic cross-sectional view of a stacked structure of a display panel according to an embodiment. The cross-section shown in FIG. 19 may substantially correspond to a pixel area.

Referring to FIG. 19, a display panel DP that may include the layers that may be provided by using the above-described deposition apparatus 1 may include a substrate SB, a transistor TR provided on the substrate SB, and/or a light emitting diode LED electrically connected to the transistor TR. The light emitting diode LED may correspond to a pixel.

The substrate SB may be a flexible substrate SB capable of being bent, folded, and/or rolled. The substrate SB may be a single layer or a multilayer including a first base layer BL1, an inorganic layer IL, and a second base layer BL2. For example, the first base layer BL1 and the second base layer BL2 may include a polymer resin such as a polyimide, a polyamide, a polyethylene terephthalate, or a combination thereof.

A barrier layer BR that prevents impurities, e.g., moisture, oxygen, etc., from penetrating may be disposed on the substrate SB. For example, the barrier layer BR may include an inorganic insulating material such as a silicon nitride (SiNₓ), a silicon oxide (SiOₓ), a silicon oxynitride (SiOₓN_{y}), or a combination thereof, and may be a single layer or a multilayer.

A buffer layer BF may be positioned on the barrier layer BR. The buffer layer BF may block impurities from the substrate SB in case that a semiconductor layer is provided, thereby improving characteristics of the semiconductor layer, and flattening a surface of the substrate SB to reduce stress on the semiconductor layer. For example the buffer layer BF may include an inorganic insulating material such as a silicon nitride, a silicon oxide, a silicon oxynitride, or a combination thereof, and may be a single layer or a multilayer. For example, the buffer layer BF may include an amorphous silicon (a-Si).

A semiconductor layer AL of the transistor TR may be disposed on the buffer layer BF. The semiconductor layer AL may include a first area, a second area, and a channel area between the first and second areas. For example, the semiconductor layer AL may include at least one of amorphous silicon, polysilicon, and an oxide semiconductor. For example, the oxide semiconductor may include at least one of zinc (Zn), indium (In), gallium (Ga), and tin (Sn). For example, the semiconductor layer AL may include a low temperature polysilicon (LTPS) or an indium-gallium-zinc oxide (IGZO).

A first gate insulating layer GI1 may be disposed on the semiconductor layer AL. The first gate insulating layer GI1 may include an inorganic insulating material such as a silicon nitride, a silicon oxide, or a silicon oxynitride, and may be a single layer or a multilayer.

A first gate conductive layer that may include a gate electrode GE of the transistor TR, a gate line GL, and a first electrode C1 of a storage capacitor CS may be disposed on the first gate insulating layer GI1. For example, the first gate conductive layer may include molybdenum (Mo), aluminium (Al), copper (Cu), titanium (Ti), the like, or a combination thereof, and may be a single layer or a multilayer.

A second gate insulating layer GI2 may be disposed on the first gate conductive layer. The second gate insulating layer GI2 may include an inorganic insulating material such as a silicon nitride, a silicon oxide, or a silicon oxynitride, and may be a single layer or a multilayer.

A second gate conductive layer that may include a second electrode C2 of the storage capacitor CS may be disposed on the second gate insulating layer GI2. For example, the second gate conductive layer may include molybdenum (Mo), aluminium (Al), copper (Cu), titanium (Ti), the like, or a combination thereof, and may be a single layer or a multilayer.

An interlayer insulating layer ILD may be disposed on the second gate insulating layer GI2 and the second gate conductive layer. The interlayer insulating layer ILD may include an inorganic insulating material such as a silicon nitride, a silicon oxide, or a silicon oxynitride, and may be a single layer or a multilayer.

A first data conductive layer that may include a first electrode SE and a second electrode DE of the transistor TR, and a data line DL may be disposed on the interlayer insulating layer ILD. The first electrode SE and the second electrode DE may be respectively electrically connected to the first region and the second region of the semiconductor layer AL through contact holes of the insulating layers GI1, GI2, and ILD. At least one of the first electrode SE and the second electrode DE may be a source electrode, and the other thereof may be a drain electrode. For example, the first data conductive layer may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), copper (Cu), or a combination thereof, and may be a single layer or a multilayer.

A first planarization layer VIA1 may be disposed on the first data conductive layer. For example, the first planarization layer VIA1 may include an organic insulating material such as a general purpose polymer such as poly(methyl methacrylate) and polystyrene, a polymer derivative having a phenol-based group, an acryl-based polymer, an imide-based polymer (for example, a polyimide), a siloxane-based polymer, or a combination thereof.

A second data conductive layer that may include a voltage line VL, a connection member CM, and the like, may be disposed on the first planarization layer VIA1. The voltage line VL may transmit a voltage such as a driving voltage, a common voltage, an initialization voltage, or a reference voltage. The connection member CM may be electrically connected to the second electrode DE of the transistor TR through a contact hole of the first planarization layer VIA1. For example, the second data conductive layer may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), copper (Cu), or a combination thereof, and may be a single layer or a multilayer.

A second planarization layer VIA2 may be disposed on the second data conductive layer. For example, the second planarization layer VIA2 may include an organic insulating material such as a general purpose polymer such as polymethylmethacrylate and polystyrene, a polymer derivative having a phenol-based group, an acryl-based polymer, an imide-based polymer, a siloxane-based polymer, or a combination thereof.

A first electrode E1 of the light emitting diode LED may be disposed on the second planarization layer VIA2. The first electrode E1 may be referred to as a pixel electrode. The first electrode E1 may be electrically connected to the connection member CM through a contact hole of the second planarization layer VIA2. Therefore, the first electrode E1 may be electrically connected to the second electrode DE of the transistor TR to receive a driving current that controls luminance of the light emitting diode LED. The transistor TR to which the first electrode E1 is electrically connected may be a driving transistor, or a transistor electrically connected to the driving transistor. The first electrode E1 may be made of a reflective conductive material or a translucent conductive material, or it may be made of a transparent conductive material. For example, the first electrode E1 may include a transparent conductive material such as an indium tin oxide (ITO) or an indium zinc oxide (IZO). The first electrode E1 may include a metal such as lithium (Li), calcium (Ca), aluminium (Al), silver (Ag), magnesium (Mg), or gold (Au), or a metal alloy thereof.

A pixel defining layer PDL may be disposed on the second planarization layer VIA2 and the first electrode E1. The pixel defining layer PDL may be referred to as a bank or a partition wall, and may have an opening overlapping the first electrode E1. For example, the pixel defining layer PDL may include an organic insulating material such as a general purpose polymer such as poly(methyl methacrylate) and polystyrene, a polymer derivative having a phenol-based group, an acryl-based polymer, an imide-based polymer, a siloxane-based polymer, or a combination thereof.

A spacer SP may be disposed on the pixel defining layer PDL. The spacer SP may include an organic insulating material such as an acryl-based polymer, an imide-based polymer, or an amide-based polymer.

A light emitting layer EL of the light emitting diode LED may be disposed on the first electrode E1. The light emitting layer EL may be provided by using the aforementioned deposition apparatus. A functional layer including at least one of a hole injection layer, a hole transport layer, an electron transport layer, and an electron injection layer may be disposed on the first electrode E1 in addition to the light emitting layer EL. The functional layer may be a common layer of the display panel DP, and may be provided by using the aforementioned deposition apparatus.

A second electrode E2 of the light emitting diode LED may be disposed on the light emitting layer EL. The second electrode E2 may be referred to as a common electrode. The second electrode E2 may have a light transmittance by forming a thin layer of a metal or a metal alloy having a low work function such as calcium (Ca), barium (Ba), magnesium (Mg), aluminium (Al), silver (Ag), the like, or a combination thereof. The second electrode E2 may include a transparent conductive oxide such as an indium tin oxide (ITO) or an indium zinc oxide (IZO). The second electrode E2 may be a common layer of the display panel DP, and may be provided by using the aforementioned deposition apparatus.

The first electrode E1, the light emitting layer EL, and the second electrode E2 of each pixel may configure the light emitting diode LED such as an organic light emitting diode. The first electrode E1 may be an anode, and the second electrode E2 may be a cathode. A light emitting area of the light emitting diode LED may correspond to a pixel.

A capping layer CPL may be disposed on the second electrode E2. The capping layer CPL may improve light efficiency through refractive index adjustment. The capping layer CPL may be disposed to entirely cover the second electrode E2. The capping layer CPL may include an organic insulating material or an inorganic insulating material.

An encapsulation layer EN may be disposed on the capping layer CPL. The encapsulation layer EN may encapsulate the light emitting diode LED to prevent moisture or oxygen from penetrating from the outside. The encapsulation layer EN may be a thin film encapsulation layer in which an organic layer EOL is disposed between a first inorganic layer EIL1 and a second inorganic layer EIL2.

A touch sensor layer TS including touch electrodes may be disposed on the encapsulation layer EN. An anti-reflective layer AR for reducing reflection of external light may be disposed on the touch sensor layer TS.

A protective film PF may be disposed under the substrate SB. The protective film PF may protect the display panel DP in the manufacturing process of the display device. For example, the protective film PF may include a polymer such as a polyethylene terephthalate, a silicon-based polymer (for example, polydimethylsiloxane), an elastomer (for example, elastomeric polyurethane), or a combination thereof.

The above description is an example of technical features of the disclosure, and those skilled in the art to which the disclosure pertains will be able to make various modifications and variations. Thus, the embodiments of the disclosure described above may be implemented separately or in combination with each other.

Therefore, the embodiments disclosed in the disclosure are not intended to limit the scope of the disclosure. The protection scope of the disclosure should be interpreted by the following claims, and it should be interpreted that all technical aspects within the equivalent scope are included in the scope of the disclosure.

The present invention may be defined by reference to the following clauses:
Clause 1. A deposition apparatus comprising:
   a chamber; and
   a deposition source disposed in the chamber and including a plurality of nozzles arranged in a first direction, wherein
   each of the plurality of nozzles includes at least one first nozzle including a first nozzle hole spraying a first deposition material and a second nozzle hole spraying a second deposition material, and
   the deposition source further includes at least one angle controlling structure surrounding the at least one first nozzle.
Clause 2. The deposition apparatus of clause 1, wherein the first nozzle hole and the second nozzle hole are arranged on a same line in the first direction.
Clause 3. The deposition apparatus of clause 1 or clause 2, wherein
   the at least one first nozzle includes one first nozzle hole and two second nozzle holes disposed on both sides of the first nozzle, and
   the first and second nozzle holes are arranged on a same line in the first direction.
Clause 4. The deposition apparatus of clause 3, wherein the at least one first nozzle has a round rhombic planar shape.
Clause 5. The deposition apparatus of any one of clauses 1 to 4, wherein
   the first nozzle hole has a "Y" cross-sectional shape, and
   the second nozzle hole has an "I" cross-sectional shape.
Clause 6. The deposition apparatus of any one of clauses 1 to 5, wherein a height of the at least one angle controlling structure is higher than a height of the at least one first nozzle.
Clause 7. The deposition apparatus of clause 6, wherein an angle formed by a center of an upper end of the at least one first nozzle and an upper end of the at least one angle controlling structure with respect to a horizontal plane is about 40° or more.
Clause 8. The deposition apparatus of any one of clauses 1 to 7, wherein the at least one angle controlling structure is cylindrical.
Clause 9. The deposition apparatus of any one of clauses 1 to 7, wherein the at least one angle controlling structure has a planar shape of a track shape, an elliptical shape, an egg-like shape, a water drop-like shape, or a round rhombic shape.
Clause 10. The deposition apparatus of any one of clauses 1 to 9, wherein
   the deposition source further includes:
      a first container accommodating the first deposition material; and
      a second container accommodating the second deposition material,
   the first nozzle hole is connected in fluid communication with the first container through a first passage, and
   the second nozzle hole is connected in fluid communication with the second container through a second passage.
Clause 11. The deposition apparatus of any one of clauses 1 to 10, wherein
   the plurality of nozzles further include at least one second nozzle including a first nozzle hole spraying the first deposition material and not including a second nozzle hole spraying the second deposition material, and
   at least part of the at least one angle controlling structure surrounds the second nozzle.
Clause 12. The deposition apparatus of clause 11, wherein
   the at least one first nozzle includes a plurality of first nozzles,
   the at least one second nozzle includes a plurality of second nozzles,
   the at least one angle controlling structure includes a plurality of angle controlling structures, a number of the at least one of angle controlling structures corresponding to a number of the at least one first and second nozzles, and
   in three adjacent nozzles included in the plurality of nozzles, two nozzles disposed at both sides are the plurality of first nozzles and one nozzle disposed in a center is the at least one second nozzle.
Clause 13. The deposition apparatus of any one of clauses 1 to 12, further comprising
   an angle limiting plate disposed on the deposition source and extending in the first direction,
   wherein the angle limiting plate includes a first angle limiting plate and a second angle limiting plate respectively disposed at one side and the other side of the plurality of nozzles in a second direction crossing the first direction.
Clause 14. The deposition apparatus of any one of clauses 1 to 13, wherein
   the at least one first nozzle includes a plurality of first nozzles, and
   a plurality of first nozzle holes and a plurality of second nozzle holes included in the plurality of first nozzles are arranged side by side in the first direction.
Clause 15. The deposition apparatus of any one of clauses 1 to 14, wherein a distance between an upper end of the first nozzle hole and an upper end of the second nozzle hole is smaller than or substantially equal to a width of the second nozzle hole.
Clause 16. A deposition apparatus comprising:
   a chamber in which a substrate and a mask are disposed to be aligned; and
   a deposition source disposed in the chamber and providing deposition materials to the substrate,
   wherein the deposition source includes:
      a plurality of nozzles arranged in a first direction and respectively including a first nozzle hole and a second nozzle hole adjacent to each other, and
      at least one angle controlling structure individually surrounding the plurality of nozzles.
Clause 17. The deposition apparatus of clause 16, wherein the first nozzle hole and the second nozzle hole are aligned in the first direction.
Clause 18. The deposition apparatus of clause 16 or clause 17, wherein each of the at least one angle controlling structure has a cylindrical three-dimensional shape.
Clause 19. The deposition apparatus of any one of clauses 16 to 18, wherein a center of the at least one angle controlling structure is a same as a center of the nozzle or a center of the first nozzle hole.
Clause 20. The deposition apparatus of any one of clauses 16 to 19, wherein
   the deposition source includes:
      a first container accommodating a first deposition material; and
      a second container accommodating a second deposition material,
   the first nozzle hole is connected in fluid communication with the first container, and
   the second nozzle hole is connected in fluid communication with the second container.

## Claims

1. A deposition apparatus comprising:
a chamber; and
a deposition source disposed in the chamber and including a plurality of nozzles arranged in a first direction, wherein
each of the plurality of nozzles includes at least one first nozzle including a first nozzle hole configured to spray a first deposition material and a second nozzle hole configured to spray a second deposition material, and
the deposition source further includes at least one angle controlling structure surrounding the at least one first nozzle.

2. The deposition apparatus of claim 1, wherein the first nozzle hole and the second nozzle hole are arranged on a same line in the first direction.

3. The deposition apparatus of claim 1 or claim 2, wherein
the at least one first nozzle includes one first nozzle hole and two second nozzle holes disposed on both sides of the first nozzle, and
the first and second nozzle holes are arranged on a same line in the first direction.

4. The deposition apparatus of claim 3, wherein the at least one first nozzle has a round rhombic planar shape.

5. The deposition apparatus of any one of claims 1 to 4, wherein
the first nozzle hole has a "Y" cross-sectional shape, and
the second nozzle hole has an "I" cross-sectional shape.

6. The deposition apparatus of any one of claims 1 to 5, wherein a height of the at least one angle controlling structure is higher than a height of the at least one first nozzle.

7. The deposition apparatus of claim 6, wherein an angle formed by a center of an upper end of the at least one first nozzle and an upper end of the at least one angle controlling structure with respect to a horizontal plane is about 40° or more.

8. The deposition apparatus of any one of claims 1 to 7, wherein the at least one angle controlling structure is cylindrical.

9. The deposition apparatus of any one of claims 1 to 7, wherein the at least one angle controlling structure has a planar shape of a track shape, an elliptical shape, an egg-like shape, a water drop-like shape, or a round rhombic shape.

10. The deposition apparatus of any one of claims 1 to 9, wherein
the deposition source further includes:
a first container configured to accommodate the first deposition material; and
a second container configured to accommodate the second deposition material,
the first nozzle hole is connected in fluid communication with the first container through a first passage, and
the second nozzle hole is connected in fluid communication with the second container through a second passage.

11. The deposition apparatus of any one of claims 1 to 10, wherein
the plurality of nozzles further include at least one second nozzle including a first nozzle hole configured to spray the first deposition material and not including a second nozzle hole configured to spray the second deposition material, and
at least part of the at least one angle controlling structure surrounds the second nozzle.

12. The deposition apparatus of claim 11, wherein
the at least one first nozzle includes a plurality of first nozzles,
the at least one second nozzle includes a plurality of second nozzles,
the at least one angle controlling structure includes a plurality of angle controlling structures, a number of the at least one of angle controlling structures corresponding to a number of the at least one first and second nozzles, and
in three adjacent nozzles included in the plurality of nozzles, two nozzles disposed at both sides are the plurality of first nozzles and one nozzle disposed in a center is the at least one second nozzle.

13. The deposition apparatus of any one of claims 1 to 12, further comprising
an angle limiting plate disposed on the deposition source and extending in the first direction,
wherein the angle limiting plate includes a first angle limiting plate and a second angle limiting plate respectively disposed at one side and the other side of the plurality of nozzles in a second direction crossing the first direction.

14. The deposition apparatus of any one of claims 1 to 13, wherein
the at least one first nozzle includes a plurality of first nozzles, and
a plurality of first nozzle holes and a plurality of second nozzle holes included in the plurality of first nozzles are arranged side by side in the first direction.

15. The deposition apparatus of any one of claims 1 to 14, wherein a distance between an upper end of the first nozzle hole and an upper end of the second nozzle hole is smaller than or substantially equal to a width of the second nozzle hole.
